# EUROPÄISCHE PATENTSCHRIFT

(11) **EP 1 520 346 B1**
(45) Veröffentlichungstag und Bekanntmachung des Hinweises auf die Patenterteilung: **23.01.2008**
(21) Anmeldenummer: 02714054.0
(22) Anmeldetag: 22.02.2002
(51) Int. Cl.: H03K 17/97

(54) **EINRICHTUNG ZUR DREHWINKELEINSTELLUNG**
DEVICE FOR ADJUSTMENT OF ROTATION ANGLES
DISPOSITIF DE REGLAGE D'ANGLES DE ROTATION

(30) Priorität: 24.02.2001 DE 10109037; 24.02.2001 DE 10109038
(43) Veröffentlichungstag der Anmeldung: 06.04.2005
(73) Patentinhaber: Marquardt GmbH, 78604 Rietheim-Weilheim (DE)
(72) Erfinder: WOLBER, Ralph, 78549 Spaichingen (DE); KIZELE, Rainer, 78532 Tuttlingen (DE); HÄUSSLER, Wolfgang, 78628 Rottweil (DE); BACHMANN, Peter, 78647 Trossingen (DE)
(74) Vertreter: Otten, Herbert
(86) Internationale Anmeldenummer: PCT/DE2002/000658
(87) Internationale Veröffentlichungsnummer: WO 2002/069452

(56) Entgegenhaltungen:
- EP-A- 0 781 980
- WO-A-00/58986
- WO-A-99/35468
- DE-A- 2 242 354
- DE-A- 2 446 193
- DE-A- 2 920 084
- US-A- 3 988 710
- US-A- 4 054 860
- US-A- 5 644 225
- US-A- 5 742 160
- US-B1- 6 188 332

## Beschreibung

Die Erfindung betrifft eine Einrichtung zur Einstellung von Drehwinkeln nach dem Oberbegriff des Patentanspruchs 1.

Derartige Einrichtungen zur Einstellung von Drehwinkeln dienen als Drehwinkelcodierer, bei denen dem jeweilig eingestellten Drehwinkel zugeordnete elektrische Signale erzeugt werden. Ein solcher Drehwinkelcodierer mit einer Handhabe zum manuellen Einstellen des Drehwinkels lässt sich mittels geeigneter Maßnahmen auch als elektrischer Drehschalter verwenden.

Aus der US-A-4 054 860 ist eine als elektrischer Drehschalter ausgebildete Einrichtung zur Einstellung von Drehwinkeln bekannt. Diese Einrichtung weist einen Stator und einen am Stator drehbeweglich gelagerten Rotor auf. Am Rotor befinden sich Magnete, und zwar Permanentmagnete, womit die Magnete mittels des Rotors bewegbar sind. Auf einem Träger der Einrichtung sind den Magneten zugewandte Magnetfeldsensoren, und zwar Hallsensoren angeordnet. Der Rotor ist zwischen mehreren Drehwinkelpositionen verstellbar, so dass die Magnetfeldsensoren aufgrund des von den Magneten hervorgerufenen Magnetfeldes ein zur jeweiligen Drehwinkelposition korrespondierendes Signal erzeugen.

In einem Ausführungsbeispiel der US-A-4 054 860 weist der Stator eine an einer Seite offene, in etwa topfförmig ausgestaltete Aufnahme auf. Die Aufnahme dient als Drehlager für den Rotor. Die Magnetfeldsensoren befinden sich auf einer Leiterplatte, die wiederum in der Aufnahme befestigt ist. Somit dient der Stator weiterhin als Träger für die Magnetfeldsensoren.

Ein vergleichbar ausgestalteter Schlüsselschalter, der als Zündschloss für eine Baumaschine dient, ist in der WO, 00/58 986 A gezeigt. In der Veröffentlichung Steiner, R. et al., "In-Plane Sensitive Vertical Trench-Hall Device", ELECTRON DEVICES MEETING, 1998, IEDM '98 TECHNICAL DIGEST., INTERNATIONAL SAN FRANCISCO, CA, USA 6-9. DEC. 1998, PISCATAWAY; NJ, USA, IEEE, US, 6. Dezember 1998, Seiten 479 bis 482 ist ein nach dem Hallprinzip arbeitender Magnetsensor beschrieben, der als Chip in CMOS-Technologie hergestellt ist. Dieser Magnetsensor ist sensitiv parallel zur seiner zweidimensionalen Chipfläche. Näheres zur Anordnung eines derartigen Magnetsensors in einem Drehschalter entnimmt man der wissenschaftlichen Veröffentlichung jedoch nicht.

Als nachteilig bei diesen bekannten Einrichtungen hat sich deren Komplexität herausgestellt, die zu einem teuren und fehleranfälligen Drehschalter führt. So benötigen diese Einrichtungen mehrere Magnete und mehrere Magnetfeldsensoren. Für die Anordnung der Magnetfeldsensoren ist ein zusätzlicher Träger notwendig. Insgesamt handelt es sich damit, auch um einen großbauenden Drehschalter, der in kompakt ausgestalteten Elektrogeräten nicht einsetzbar ist.

Insbesondere ist ein solcher Drehschalter nicht zur Anordnung auf einer Leiterplatte geeignet, die in einer Bedienblende eines Elektrogerätes, wie beispielsweise einer Wasch- oder Geschirrspülmaschine, die Elektronik zur Auswertung der Signale der Magnetfeldsensoren aufnimmt.

Außerdem erhält man in der diese Drehschalter betreffenden Druckschriften keinen Hinweis auf Toleranzprobleme bei der Montage o. dgl., die zu einer Verfälschung der in der Ausgangsstellung des Rotors von den Magnetsensoren erzeugten Signalen führen können. Des Weiteren weist auch der Magnetfeldsensor an sich, bei dem es sich um eine integrierte . Halbleiterschaltung handelt, aufgrund der Herstellung bedingte Toleranzen bei den erzeugten Signalen auf. Damit ist der bekannte Drehschalter ebenso wenig für eine automatisierte Massenfertigung geeignet.

In der US 5 644 225 A wird zwar eine Kalibrierung einer Einrichtung zur Messung von Drehwinkeln, die einen Permanentmagneten sowie einen Magnetsensor aufweist, vorgeschlagen. Die Kalibrierung erfolgt dort in aufwendiger Weise durch Aufmagnetisierung eines entsprechenden zusätzlichen Magnetfeldes auf den Permanentmagneten. Diese Art der Kalibrierung erscheint daher für einen kleinbauenden Drehschalter wenig geeignet.

Der Erfindung liegt die Aufgabe zugrunde, eine in einfacher Weise zur Anordnung auf einer Leiterplatte, beispielsweise an einer Bedienblende o. dgl-, geeignete Einrichtung zur Einstellung von Drehwinkeln zu schaffen, die insbesondere kleinbauend ist. Zudem kann die Einrichtung derart ausgestaltet sein, dass ein Ausgleich der Toleranzen nach der Montage, insbesondere in einfacher Art und Weise gestattet ist.

Diese Aufgabe wird bei einer gattungsgemäßen Einrichtung zur Einstellung von Drehwinkeln durch die kennzeichnenden Merkmale des Anspruchs 1 gelöst.

Bei der erfindungsgemäßen, insbesondere als ein elektrischer Drehschalter ausgestalteten Einrichtung weist der Stator eine an einer Seite offene, insbesondere in etwa topfförmig ausgestaltete Aufnahme auf, die ein Drehlager für den Rotor bildet. Weiter ist der Magnet als zweidimensional, diametral magnetisierter Permanentmagnet ausgestaltet und in der Drehachse des Rotors angeordnet. Der Magnetfeldsensor ist als für Magnetfelder parallel zu seiner Chipfläche zweidimensional sensitiver Hallsensor ausgebildet und an der der offenen Seite abgewandten Seite der Aufnahme befestigt. Der Magnetfeldsensor ist dabei in der Aufnahme am Stator und/oder einem im Stator befestigten Teil angeordnet, womit der Stator neben seiner Funktion als Drehlagerung für den Rotor gleichzeitig als Träger für den Magnetfeldsensor dient. Beim Stator handelt es sich also um ein Multifunktionsbauteil, in dem mehrere, bisher getrennt realisierte Funktionalitäten der Einrichtung, nämlich als Träger, als Drehlager sowie gegebenenfalls als Gehäuse, integriert sind.

Ebenso kann bei der erfindungsgemäßen Einrichtung der Magnet zur Einstellung seiner Position gegenüber dem Rotor verstellbar angeordnet sein, womit eine Justierung der Position des Magneten in einer Drehwinkelposition des Rotors im Hinblick auf das vom Magnetfeldsensor erzeugte Signal ermöglicht ist. Bei der Justierung wird somit der vom Rotor festgelegte mechanische Nullpunkt mit dem vom Magnetfeldsensor bestimmten elektrischen Nullpunkt der Einrichtung zusammengeführt.

Weitere Ausgestaltungen der Erfindung sind Gegenstand der abhängigen Ansprüche.

Der Stator und/oder der Rotor können aus Kunststoff bestehen, insbesondere aus einem thermoplastischen Kunststoff. Beispielsweise kann hierfür Polyamid gewählt werden. Zweckmäßigerweise sind dann der Stator und/oder der Rotor als ein Spritzgießteil hergestellt, womit diese Bauteile in einfacher und kostengünstiger Weise herstellbar sind.

Besonders kompakt lässt sich die Einrichtung zur Einstellung von Drehwinkeln ausgestalten, indem der Rotor im Wesentlichen, insbesondere vollständig, in der Aufnahme befindlich ist. Bei dieser Ausgestaltung wirkt eine im Inneren des Stators befindliche Fläche der Aufnahme in direkter Weise als Drehlager. Um den Rotor in der Aufnahme gegen Herausfallen zu sichern, können zwischen dem Stator sowie dem Rotor in der Aufnahme zusammenwirkende Rastelemente vorgesehen sein. Der Magnetfeldsensor kann an der der offenen Seite abgewandten Seite der Aufnahme befestigt sein, also an der Unterseite des Stators.

Platzsparend lassen sich die Leiterbahnen zur elektrischen, Verbindung des Magnetfeldsensors im Stator anordnen, wobei die Leiterbahnen zweckmäßigerweise bis in die Aufnahme reichen. Der Magnetfeldsensor kann dann direkt auf den Leiterbahnen aufgelötet, aufgeschweißt, mittels Leitkleber aufgeklebt o. dgl. sein, so dass es sich bei den Leiterbahnen gleichzeitig um das am Stator befestigte Teil zur Anordnung des Magnetfeldsensors handelt. Handelt es sich beim Magnetfeldsensor um einen gehäusten Chip mit Anschlüssen, so können dabei die Anschlüsse zur elektrischen Kontaktierung mit den Leiterbahnen verlötet sein. Zur einfachen Verarbeitung bietet es sich dann an, den Chip in der Art eines SMD(Surface Mounted Device)-Bauteils auszugestalten. Handelt es sich beim Magnetfeldsensor um einen ungehäusten Chip, so können Bonddrähte, die insbesondere am Chip angeschweißt sind, zur elektrischen Kontaktierung mit den Leiterbahnen dienen.

Kostengünstig ist es, die Leiterbahnen in der Art eines Stanzgitters aus Metall auszubilden. Das Stanzgitter kann dann direkt bei der Herstellung des Stators in einem Arbeitsgang in den Kunststoff für das Spritzgießteil eingespritzt werden. Alternativ lassen sich die Leiterbahnen auch in der Art eines MID(Moulded Interconnected Device)-Bauteils in den Stator einbringen. Beispielsweise kann dies durch Verwendung von metallisierten Kunststoff für die Leiterbahnen geschehen.

Um ein separates Gehäuse einzusparen, kann das Äußere des Stators in der Art eines Gehäuses ausgestaltet sein. Zur einfachen Befestigung der Einrichtung zur Einstellung von Drehwinkeln bietet es sich dann an, Rast- und/oder Schnapphaken am Gehäuse zur Befestigung des Stators an einer Halterung anzuordnen. Zweckmäßigerweise ist der Stator mit seiner offenen Seite der Aufnahme der Halterung zugewandt, so daß die Halterung die Öffnung im Stator abdeckt und gleichzeitig einen Gehäuseabschluß bildet Besonders vorteilhaft im Hinblick auf die Kosten sowie die Kompaktheit ist es, wenn es sich bei der Halterung um eine Leiterplatte handelt Dann können die Leiterbahnen im Stator mit zugehörigen Leiterbahnen auf der Leiterplatte kontaktieren, d.h. die elektrische Verbindung zum Drehschalter erfolgt über die Leiterplatte. Es bietet sich dann weiterhin an, eine Elektronik zur Auswertung der vom Magnetfeldsensor erzeugten Signale auf der Leiterplatte anzuordnen. Gegebenenfalls kann die Leiterplatte noch mit einer Blende für ein elektrisches Gerät o. dgl. versehen sein, so daß der erfindungsgemäß ausgestaltete Drehschalter zur direkten Anordnung in einfacher Art und Weise an der Blende eines Elektrogeräts geeignet ist.

Zur ergonomischen Bedienung des Drehschalters kann der Rotor an der offenen Seite der Aufnahme eine Ausnehmung besitzen, in die eine Handhabe einsteckbar ist Beispielsweise kann die Handhabe mittels einer Welle manuell drehbar sein. Befindet sich die Handhabe an der dem Gehäuse abgewandten Seite der Halterung, so kann in der Halterung eine mit der offenen Seite der Aufnahme im Stator korrespondierende Öffnung befindlich sein, durch die die Welle zum Einstecken in die Ausnehmung hindurchreicht.

Insbesondere bei einer als elektrischer Drehschalter dienenden Einrichtung sind die Drehwinkelpositionen des Rotors bevorzugterweise als Raststellungen ausgestaltet, womit eindeutige Schaltstellungen in ergonomischer Weise erzielbar sind. Der Drehschalter gibt vor allem Signalspannungen aus. Daher kann es vorteilhaft sein, wenn im Gehäuse des Drehschalters zusätzlich ein elektrischer Schalter mit einem herkömmlichen elektromechanischen Kontaktsystem als Netzschalter befindlich ist, so daß der Drehschalter gleichzeitig auch noch die Netzspannung schalten kann. Ein derartiger Drehschalter ist universell in einem Elektrogerät verwendbar.

Wie bereits erwähnt, kann zum Ausgleich von Toleranzen, die bei der Herstellung der erfindungsgemäßen Einrichtung zur Einstellung von Drehwinkeln auftreten können, eine Justierung vorgesehen sein. Besonders einfach läßt sich der Justiervorgang für das nachträgliche Einstellen des Magneten auf die Ausgangsstellung durchführen, wenn der Magnet drehbar am Rotor gelagert ist. Zweckmäßigerweise wird hierzu eine Aufnahme im Rotor bereitgestellt, die dem Magnetfeldsensor zugewandt ist. Zusätzlich kann ein Einstellmittel zur Einstellung der Position des Magneten zwischen dem Magneten und dem Rotor angeordnet sein, um so eine reproduzierbare Justierbarkeit mit einfachen Mitteln zu gewährleisten. Es bietet sich an, das Einstellmittel als ein in der Aufnahme drehbar am Rotor gelagertes Zwischenstück auszubilden, wobei der Magnet seinerseits am Zwischenstück befestigt ist

Trotz deren Justierbarkeit läßt sich die Einrichtung zur Einstellung von Drehwinkeln besonders kompakt dadurch ausgestalten, daß der Magnet zur Justierung von der Außenseite des Stators zugänglich ist. Der Zugang kann über eine an einer Seite offene, als Drehlager für den Rotor dienende Aufnahme im Stator vorgesehen sein. Im Rotor befindet sich dann zweckmäßigerweise ein Durchbruch, der von der der offenen Seite der Aufnahme zugewandten Fläche des Rotors bis zum Magneten und/oder bis zum Zwischenstück reicht. Zur feinfühligen Justierung kann weiterhin dem Durchbruch zugewandt im Magnet und/oder im Zwischenstück eine Art von Torx, Kreuzschlitz o.dgl. -Aufnahme befindlich sein. Dadurch ist die Justierung über den Durchbruch mittels eines in die Aufnahme eingreifenden Werkzeuges, beispielsweise mittels eines Schraubendrehers, ermöglicht.

Um die justierte Lage des Magneten zu sichern, kann diese verdrehsicher mit dem Rotor verbunden werden. Hierzu bietet es sich an, den Magnet und/oder das Zwischenstück nach dem Justieren mit dem Rotor zu verkleben, zu verschweißen, zu vergießen oder in sonstiger Weise zu fixieren.

In kompakter und auch durch Einsparung von Bauteilen kostengünstiger Ausgestaltung ist der Magnet aus einem Magaetpartikel und Kunststoff aufweisenden Material hergestellt. Dieses Material wird in Gestalt eines derartigen Körpers geformt, und zwar mittels Spritzgießen, daß der Körper gleichzeitig das Zwischenstück sowie den Magneten darstellt

Die mit der Erfindung erzielten Vorteile bestehen insbesondere darin, daß der Stator in einem einzigen Bauteil mehrere Funktionalitäten gleichzeitig realisiert. Außerdem läßt sich ein separates Bauteil für die Sensoraufnahme, beispielsweise die herkömmlicherweise verwendete Leiterplatte, einsparen. Dadurch werden Montagevorteile erzielt, insbesondere ist die Einrichtung automatengerecht zu fertigen. Außerdem kann die Einrichtung sehr kleinbauend ausgestaltet werden, womit deren Einsatz auch bei beschränkten Platzverhältnissen möglich ist. Schließlich ist die Einrichtung auch kostengünstiger im Vergleich zu herkömmlichen Einrichtungen.

Weiterhin wird aufgrund der direkten Platzierung des Magnetfeldsensors auf dem Stator eine Reduzierung der Toleranzkette erreicht Alle auftretenden mechanischen Toleranzen zwischen dem Magnetfeldsensor und dem Magnet sind eliminiert. Gegebenenfalls kann hierzu eine Justierung des Magneten durchgeführt werden, bei der ein Zusammenführen des mechanischen mit dem elektrischen Nullpunkt der Einrichtung erfolgt. Dadurch wird eine definierte Ausgangssituation geschaffen, die es erlaubt eine größere Anzahl von Drehwinkelpositionen bzw. Schaltstellungen sicher zu unterscheiden. Damit besitzt die Einrichtung trotz kompakter Bauweise mehr Drehwinkelpositionen als eine herkömmliche Einrichtung und kann dadurch auch höheren Anforderungen gerecht werden.

Ausführungsbeispiele der Erfindung mit verschiedenen Weiterbildungen und Ausgestaltungen sind in den Zeichnungen dargestellt und werden im folgenden näher beschrieben. Es zeigen
- Fig. 1: eine als Drehschalter ausgebildete Einrichtung zur Einstellung von Drehwinkeln in perspektivischer Ansicht und teilweise aufgeschnitten,
- Fig.2: den Stator als Einzelteil aus Fig. 1,
- Fig. 3: einen Schnitt entlang der Linie 3-3 aus Fig. 2 und
- Fig. 4: einen Schnitt wie in Fig. 3 entsprechend einer anderen Ausgestaltung.

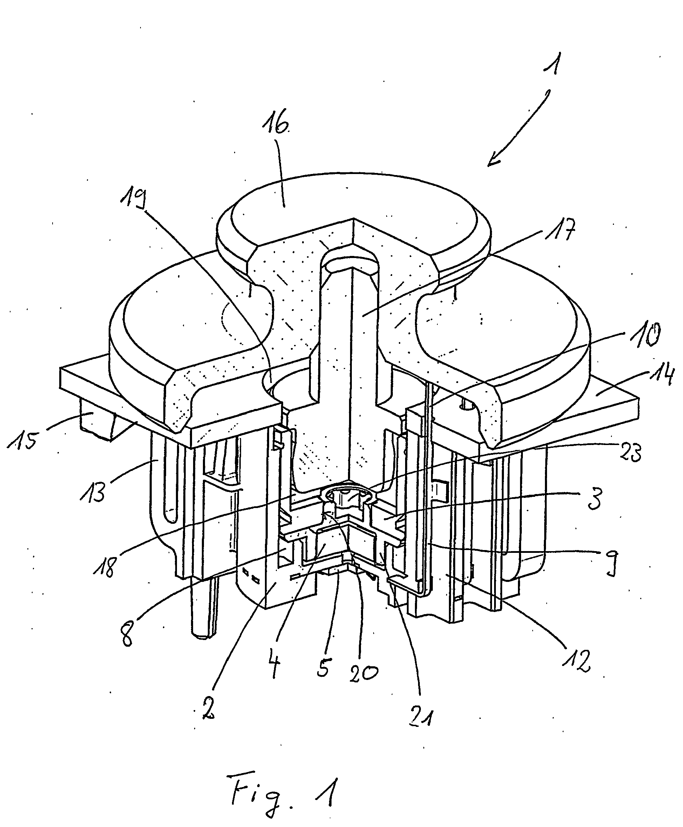

In Fig. 1 ist eine Einrichtung zur Einstellung von Drehwinkeln gezeigt, die vor allem als elektrischer Drehschalter 1 dient. Ein solcher Drehschalter 1 kann beispielsweise als Programmwählschalter in der Blende eines elektrischen Haushaltsgerätes, wie einer Waschmaschine, einer Geschirrspülmaschine o. dgl. angeordnet sein.

Der Drehschalter 1 besitzt einen Stator 2 sowie einen am Stator 2 drehbeweglich gelagerten Rotor 3. Mittels des Rotors 3 ist ein Magnet 4 bewegbar. Dem Magneten 4 ist ein Magnetfeldsensor 5 zugeordnet. Insbesondere handelt es sich bei dem Magneten 4 um einem zylinderförmigen Permanentmagneten, der bevorzugterweise zweidimensional, diametral magnetisiert ist, d.h. der eine im Querschnitt halbkreisförmige Halbzylinder stellt den Nord- und der andere Halbzylinder den Südpol des Magneten dar. Bei dem Magnetfeldsensor handelt es sich insbesondere um einen Hallsensor, der bevorzugterweise zweidimensional, für Magnetfelder parallel zur Chipfläche des Hallsensors sensitiv ist. Der Rotor 3 ist zwischen wenigstens zwei Drehwinkelpositionen verstellbar, wodurch sich das vom Magneten 4 im Bereich des Magnetfeldsensors 5 erzeugte Magnetfeld ändert, so daß der Magnetfeldsensor 5 ein zur jeweiligen Drehwinkelposition korrespondierendes Signal erzeugt.

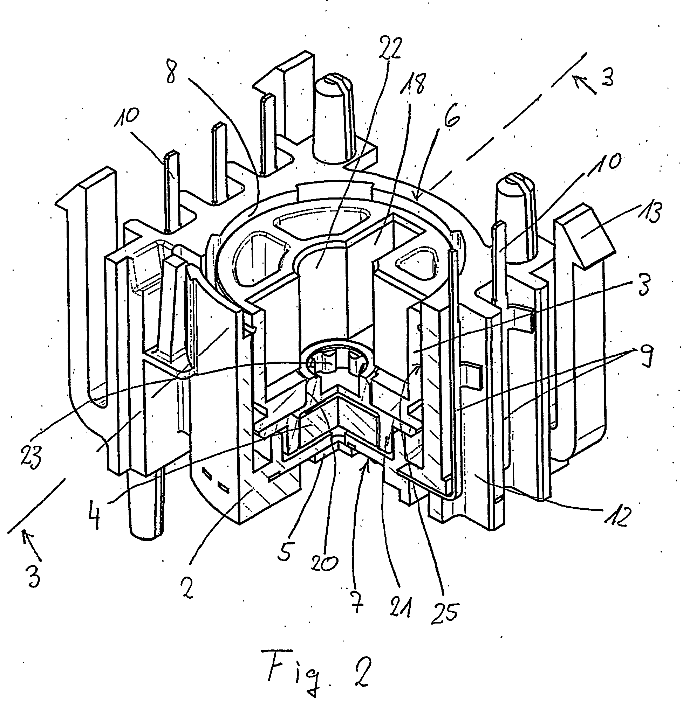

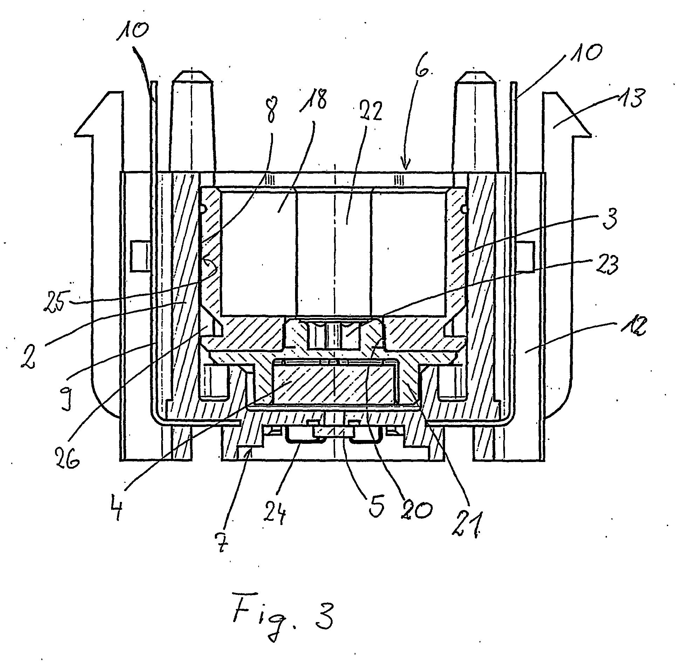

Erfindungsgemäß weist der Stator 2 eine an einer Seite 6 offene Aufnahme 8 auf, die in etwa topfförmig ausgestaltet ist, wie anhand der Fig. 2 oder 3. zu erkennen ist Die Aufnahme 8 bildet ein Drehlager für den Rotor 3. Der Magnetfeldsensor 5 ist in der Aufnahme 8 direkt am Stator 2 und/oder an einem im Stator 2 befestigten Teil angeordnet. Aufgrund der Befestigung des Magnetfeldsensors 5 am Stator 2, dient der Stator 2 gleichzeitig als Träger für den Magnetfeldsensor 5, so daß die ansonsten im Schalter übliche Trägerplatte für den Magnetfeldsensor entfällt. Außerdem erfüllt der Stator 2 zusätzlich die Funktion des Drehlager für den Rotor 3 und übt gegebenenfalls noch die Gehäusefunktion aus.

Im folgenden sollen diverse Weiterbildungen sowie weitere Ausgestaltungen des Drehschalters 1 näher erläutert werden.

An der der offenen Seite 6 abgewandten Seite 7 der Aufnahme 8 ist der Magnetfeldsensor 5 befestigt Der Rotor 3 befindet sich im wesentlichen in der Aufnahme 8, was anhand von Fig. 1 zu erkennen ist Der Kompaktheit halber bietet es sich an, daß sich der Rotor 3 vollständig innerhalb der Aufnahme 8 befindet Eine im Inneren des Stators 2 befindliche Fläche 25 der Aufnahme 8 wirkt dann als Drehlager. Um den Rotor 3 gegen Herausfallen aus der Aufnahme 8 zu sichern, bietet es sich an, zwischen dem Stator 2 sowie dem Rotor 3 zusammenwirkende, in Fig. 3 gezeigte Rastelemente 26 vorzusehen. Weiterhin können sich im Stator 2 integrierte Leiterbahnen 9 zur elektrischen Verbindung des Magnetfeldsensors 5 mit äußeren Anschlüssen 10 des Drehschalters 1 befinden. Die Leiterbahnen 9 reichen bis in die Aufnahme 8. Vorteilhafterweise ist damit der Stator 2 als Multifunktionsteil ausgebildet, das sowohl den Rotor 3 als auch den Magnetfeldsensor 5 aufnimmt sowie die elektrische Verbindung des Magnetfeldsensors 5 zur Verfügung stellt.

Der Stator 2 und/oder der Rotor 3 bestehen aus Kunststoff, und zwar aus einem thermoplastischen Kunststoff. Beispielsweise kann es sich hierbei um Polyamid handeln. Zweckmäßigerweise sind der Stator 2 und/oder der Rotor 3 als ein Spritzgießteil hergestellt In einer Ausgestaltung sind die Leiterbahnen 9 in der Art eines Stanzgitters aus Metall ausgebildet. Bei der Herstellung des Stators 2 kann dann das Stanzgitter in den Kunststoff für das Spritzgießteil eingespritzt werden. Hierbei kann der Magnetfeldsensor 5 auch von dem stabilen Stanzgitter getragen sein, womit es sich bei diesen Leiterbahnen 9 dann um das im Stator 2 befestigte Teil zur Anordnung des Magnetfeldsensors 5 handelt. In einer anderen Ausgestaltung sind die Leiterbahnen 9 in der Art eines MID(Moulded Interconnected Device)-Bauteils in den Stator 2 eingebracht. Beispielsweise können hierbei die Leiterbahnen 9 von metallisierten Kunststoff gebildet werden, der bei der Herstellung des Spritzgießteils für den Stator 2 miteingespritzt wird und/oder nachträglich metallisch galvanisiert wird.

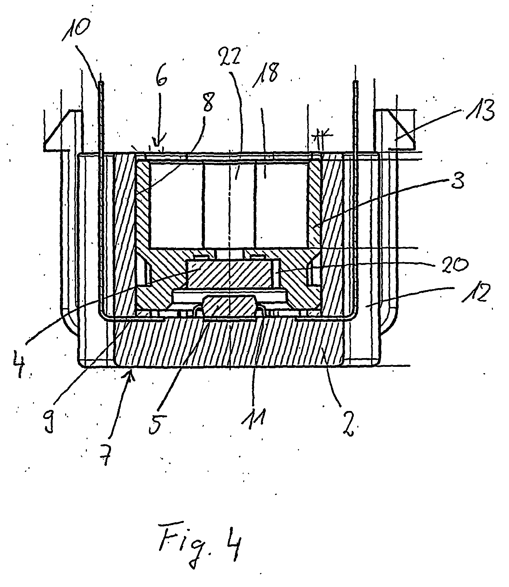

Wie in Fig. 4 zu sehen ist, ist der Magnetfeldsensor 5 als gehäuster Chip und zwar in der Art eines SMD(Surface Mounted Device)-Bauteils ausgestaltet. Der Chip besitzt Anschlüsse 11, die wiederum zur elektrischen Kontaktierung mit den Leiterbahnen 9 verlötet sind. Ebensogut kann der Magnetfeldsensor 5 auch als ein ungehäuster Chip vorliegen, was in Fig. 3 gezeigt ist. Zur elektrischen Kontaktierung mit den Leiterbahnen 9 dienen hierbei Bonddrähte 24, die einerseits am Chip und andererseits an der Leiterbahn 9 angeschweißt sind. Letztgenannter Fall bietet gegenüber einem gehäusten Chip vor allem eine Platzeinsparung, womit der Drehschalter 1 noch kompakter ausgestaltet werden kann.

Es kann sich anbieten, das Äußere des Stators 2 in der Art eines Gehäuses 12 auszugestalten, wie näher anhand von Fig. 2 hervorgeht Am Gehäuse 12 sind Rast- und/oder Schnapphaken 13 zur Befestigung des Stators 2 an einer in Fig. 1 gezeigten Halterung 14 angeordnet Zweckmäßigerweise kann der Stator 2 mit der offenen Seite 6 der Aufnahme 8 der Halterung 14 zugewandt sein. Bei der Halterung 14 handelt es sich um eine Leiterplatte, wobei die Leiterbahnen 9 im Stator 2 über die elektrischen Anschlüsse 10 mit zugehörigen Leiterbahnen auf der Leiterplatte kontaktieren. Auf der Leiterplatte kann sich eine in Fig. 1 lediglich schematisch angedeutete Elektronik 15 zur Auswertung der vom Magnetfeldsensor 5 erzeugten Signale befinden. Die als Halterung 14 ausgebildete Leiterplatte kann noch mit einer Blende für ein elektrisches Gerät o. dgl. versehen sein. Gegebenenfalls kann die Halterung 14 auch selbst als Blende für das Gerät dienen.

Wie der Fig. 1 zu entnehmen ist, ist der Drehschalter 1 mit einer Handhabe 16 als Betätigungsorgan ausgestattet. Mit Hilfe der Handhabe 16 ist die manuelle Drehung des Rotors 3 ermöglicht. Die Handhabe 16 weist eine Welle 17 auf, die zum Einstecken der Handhabe 16 in eine an der offenen Seite 6 der Aufnahme 8 im Rotor 3 befindliche, in Fig. 2 sichtbare Ausnehmung 18 dient. Bevorzugterweise befindet sich die Handhabe 16 an der dem Gehäuse 12 abgewandten Seite der Halterung 14. In der Halterung 14 ist dann eine mit der offenen Seite 6 der Aufnahme 8 im Stator 2 korrespondierende Öffnung 19 befindlich. Durch diese Öffnung 19 reicht die Welle 17 zum Einstecken in die Ausnehmung 18 hindurch.

In der Blende am Elektrogerät, in der die Handhabe 16 angeordnet ist, kann eine nicht weiter gezeigte Verrastung für die Schaltstellungen des Drehschalters 1 vorgesehen sein. Bevorzugterweise sind jedoch die Schaltstellungen des Drehschalters 1 realisiert, indem die Drehwinkelpositionen des Rotors 3 als Raststellungen ausgestaltet sind, was allerdings in den Zeichnungen ebenfalls nicht näher gezeigt ist. Weiterhin kann im Gehäuse 12 des Drehschalters 1 noch ein nicht weiter gezeigter, konventioneller elektrischer Schalter untergebracht sein, der als Netzschalter für das Elektrogerät dient. Zweckmäßigerweise ist dieser Netzschalter ebenfalls mittels der Handhabe 16 schaltbar. Ein solcher Drehschalter 1 kann dann sowohl Netzspannung schalten als auch den Schaltstellungen der Handhabe 16 entsprechende Signalspannungen erzeugen, die der Auslösung bestimmter Funktionen des Elektrogeräts dienen.

Bei der Montage des Drehschalters 1 wird die Lage des Magneten 4 zum Magnetfeldsensor 5 festgelegt. Von dieser Lage hängt das vom Magnetfeldsensor 5 abgegebene Signal in den Drehwinkelpositionen des Rotors 3 ab. Oft bieten die Magnetfeldsensoren 5 zwar die Möglichkeit eines digitalen Abgleichs für die Nullposition, wobei nach der Montage der Magnetfeldsensor 5 durch Anlegen eines entsprechenden Signals auf "Null" gestellt wird. Jedoch ist aufgrund der im Magnetfeldsensor 5 auftretenden Toleranzen in Verbindung mit einer mechanischen Rastung der Handhabe 16, der Welle 17 bzw. des Rotors 3 dann lediglich eine geringe Anzahl von Schaltstellungen sicher reproduzierbar. Zum Ausgleich von Toleranzen bei der Montage ist nun entsprechend der Erfindung der Magnet 4 zur Einstellung seiner Lage gegenüber dem Rotor 3 verstellbar angeordnet. Dadurch ist eine Justierung der Lage des Magneten 4 in einer Drehwinkelposition des Rotors 3 ermöglicht, so daß der Magnetfeldsensor 5 das der Nullposition zugeordnete Signal ausgibt.

Wie in Fig. 3 zu sehen ist, ist zur Einstellung seiner Lage der Magnet 4 bevorzugterweise drehbar am Rotor 3 gelagert. Hierzu befindet sich im Rotor 3 eine dem Magnetfeldsensor 5 zugewandte Aufnahme 20. Es bietet sich dann weiter an, daß ein Einstellmittel zur Einstellung der Position des Magneten 4 zwischen dem Magneten 4 und dem Rotor 3 angeordnet ist. Das Einstellmittel ist als ein in der Aufnahme 20 drehbar am Rotor 3 gelagertes Zwischenstück 21 ausgebildet. Der Magnet 4 ist wiederum am Zwischenstück 21 befestigt.

Zur Justierung ist nun der Magnet 4 von der Außenseite des Stators 2 und damit auch des Gehäuses 12 zugänglich. Hierzu wird die an der einen Seite 6 offene Aufnahme 8 verwendet, die gleichzeitig als Drehlager für den Rotor 3 im Stator 2 dient Zusätzlich ist im Rotor 3 ein Durchbruch 22 befindlich. Der Durchbruch 22 reicht von der der offenen Seite 6 der Aufnahme 8 zugewandten Fläche des Rotors 3 bis zum Magneten 4 und/oder bis zum Zwischenstück 21. Dem Durchbruch 21 zugewandt befindet sich im Magnet 4 und/oder im Zwischenstück 21 eine Art von Torx, Kreuzschlitz o.dgl. -Aufnahme 23. Dadurch ist die Justierung über den Durchbruch 22 mittels eines in die Aufnahme 23 eingreifenden Werkzeuges, beispielsweise mittels eines Schraubendrehers, ermöglicht

Nach der Montage wird der Rotor 3 in die Nullposition bewegt. Dann wird bei dem beispielsweise durch die Verrastung in der Nullposition festgehaltenen Rotor 3 mittels des Werkzeuges der Magnet 4 solange gedreht bis der Magnetfeldsensor 5 das der Nullposition zugeordnete Signal ausgibt Anschließend wird die justierte Position des Magneten 4 verdrehsicher mit dem Rotor 3 verbunden. Hierzu kann der Magnet 4 und/oder das Zwischenstück 21 nach dem Justieren mit dem Rotor 3 verklebt, verschweißt, vergossen o. dgl. werden. Danach kann dann die Handhabe 16 in die Ausnehmung 18 eingesteckt werden, wonach der Durchbruch 22 verschlossen ist

In einer anderen Ausgestaltung, die jedoch in den Zeichnungen nicht weiter gezeigt ist, ist der Magnet 4 nicht an einem Zwischenstück 21 angeordnet Hier besteht der Magnet aus einem Magnetpartikel und Kunststoff aufweisenden Material. Dieses Material ist in Gestalt eines Körpers geformt, der gleichzeitig die jeweilige Funktion des Magneten 4 und des Zwischenstücks 21 ausübt. Ein derartiger Körper stellt also gleichzeitig das Zwischenstück 21 sowie den Magnet 4 dar, womit ein Teil bei der Herstellung des Drehschalters 1 eingespart wird. Der Körper kann beispielsweise durch Spritzgießen aus diesem Material hergestellt werden.

### Bezugszeichen-Liste:

- 1:: elektrischer Drehschalter
- 2:: Stator
- 3:: Rotor
- 4:: Magnet
- 5:: Magnetfeldsensor
- 6,7:: Seite (des Stators)
- 8:: Aufnahme (im Stator)
- 9:: Leiterbahn
- 10:: elektrischer Anschluß (am Stator)
- 11:: Anschluß (von Mägnetfeldsensor)
- 12:: Gehäuse
- 13:: Rast-/Schnapphaken
- 14:: Halterung
- 15:: Elektronik
- 16:: Handhabe
- 17:: Welle (an Handhabe)
- 18:: Ausnehmung (in Rotor für Welle)
- 19:: Öffnung (in Halterung)
- 20:: Aufnahme (im Rotor für Magnet)
- 21:: Zwischenstück
- 22:: Durchbruch
- 23:: (Torx-/Kreuzschlitz-)Aufnahme
- 24:: Bonddraht
- 25:: Fläche (in der Aufnahme)
- 26:: Rastelement

## Patentansprüche

1. Einrichtung zur Einstellung von Drehwinkeln, insbesondere elektrischer Drehschalter (1),mit einem Stator (2), der eine an einer Seite (6) offene, in etwa topfförmig ausgestaltete Aufnahme (8) aufweist, mit einem Rotor (3), der am Stator (2) drehbeweglich in der Aufnahme (8) als ein Drehlager gelagert ist, so dass der Rotor (3) zwischen wenigstens zwei Drehwinkelpositionen verstellbar ist, mit einem mittels des Rotors (3) bewegbaren Magneten (4), und mit einem dem Magneten (4) zugeordneten Magnetfeldsensor (5) zur Erzeugung eines zur Drehwinkelposition korrespondierenden Signals, wobei der Magnetfeldsensor (5) in der Aufnahme (8) am Stator (2) und/oder einem im Stator (2) befestigten Teil angeordnet ist, derart dass der Stator (2) als Träger für den Magnetfeldsensor (5) dient, **dadurch gekennzeichnet, dass** der Magnet (4) als zweidimensional, diametral magnetisierter zylinderförmiger Permanentmagnet ausgestaltet ist, dass der Magnetfeldsensor (5) als für Magnetfelder parallel zu seiner Chipfläche zweidimensional sensitiver Hallsensor ausgebildet ist, und dass der Magnetfeldsensor (5) an der Unterseite des Stators (2) befestigt ist, welche sich an der der offenen Seite (6) abgewandten Seite (7) der Aufnahme (8) befindet.

2. Einrichtung zur Einstellung von Drehwinkeln nach Anspruch 1, **dadurch gekennzeichnet, dass** der Stator (2) und/oder der Rotor (3) aus Kunststoff bestehen, insbesondere aus einem thermoplastischen Kunststoff, beispielsweise aus Polyamid, und dass vorzugsweise der Stator (2) und/oder der Rotor (3) als ein Spritzgießteil hergestellt ist.

3. Einrichtung zur Einstellung von Drehwinkeln nach Anspruch 1 oder 2, **dadurch gekennzeichnet, dass** der Rotor (3) im wesentlichen, insbesondere vollständig, in der Aufnahme (8) befindlich ist, derart dass eine im inneren des Stators (2) befindliche Fläche (25) der Aufnahme (8) als Drehlager wirkt, und dass vorzugsweise Rastelemente (26) zwischen dem Stator (2) sowie dem Rotor (3) derart zusammenwirken, dass der Rotor (3) in der Aufnahme (8) gegen Herausfallen gesichert ist.

4. Einrichtung zur Einstellung von Drehwinkeln nach Anspruch 1, 2 oder 3, **dadurch gekennzeichnet, dass** sich im Stator (2) Leiterbahnen (9) zur elektrischen Verbindung des Magnetfeldsensors (5) befinden, und dass vorzugsweise die Leiterbahnen (9) bis in die Aufnahme (8) reichen, wobei es sich insbesondere bei den Leiterbahnen (9) um das im Stator (2) befestigte Teil zur Anordnung des Magnetfeldsensors (5) handelt.

5. Einrichtung zur Einstellung von Drehwinkeln nach einem der Ansprüche 1 bis 4, **dadurch gekennzeichnet, dass** die Leiterbahnen (9) in der Art eines Stanzgitters aus Metall ausgebildet sind, wobei insbesondere das Stanzgitter bei der Herstellung des Stators (2) in den Kunststoff für das Spritzgießteil eingespritzt wird.

6. Einrichtung zur Einstellung von Drehwinkeln nach einem der Ansprüche 1 bis 4, **dadurch gekennzeichnet, dass** die Leiterbahnen (9) in der Art eines MID(Moulded Interconnected Device)-Bauteils in den Stator (2) eingebracht sind, beispielsweise durch metallisierten Kunststoff für die Leiterbahnen (9).

7. Einrichtung zur Einstellung von Drehwinkeln nach einem der Ansprüche 1 bis 6, **dadurch gekennzeichnet, dass** der Magnetfeldsensor (5) als gehäuster Chip mit Anschlüssen (11), insbesondere in der Art eines SMD(Surface Mounted Device)-Bauteils ausgestaltet ist, wobei die Anschlüsse (11) zur elektrischen Kontaktierung mit den Leiterbahnen (9) verlötet sind.

8. Einrichtung zur Einstellung von Drehwinkeln nach einem der Ansprüche 1 bis 6, **dadurch gekennzeichnet, dass** der Magnetfeldsensor (5) als ungehäuster Chip ausgestaltet ist, wobei Bonddrähte (24), die insbesondere am Chip angeschweißt sind, zur elektrischen Kontaktierung mit den Leiterbahnen (9) dienen.

9. Einrichtung zur Einstellung von Drehwinkeln nach einem der Ansprüche 1 bis 8, **dadurch gekennzeichnet, dass** das Äußere des Stators (2) in der Art eines Gehäuses (12) ausgestaltet ist, dass vorzugsweise Rast- und/oder Schnapphaken (13) am Gehäuse (12) zur Befestigung des Stators (2) an einer Halterung (14) angeordnet sind, wobei insbesondere der Stator (2) mit der offenen Seite (6) der Aufnahme (8) der Halterung (14) zugewandt ist.

10. Einrichtung zur Einstellung von Drehwinkeln nach einem der Ansprüche 1 bis 9, **dadurch gekennzeichnet, dass** es sich bei der Halterung (14) um eine Leiterplatte handelt, die gegebenenfalls mit einer Blende für ein elektrisches Gerät o. dgl. versehen ist, wobei insbesondere die Leiterbahnen (9) im Stator (2) mit zugehörigen Leiterbahnen auf der Leiterplatte kontaktieren, und dass vorzugsweise eine Elektronik (15) zur Auswertung der vom Magnetfeldsensor (5) erzeugten Signale auf der Leiterplatte befindlich ist.

11. Einrichtung zur Einstellung von Drehwinkeln nach einem der Ansprüche 1 bis 10, **dadurch gekennzeichnet, dass** der Rotor (3) an der offenen Seite (6) der. Aufnahme (8) eine Ausnehmung (18) zum Einstecken einer Handhabe (16), beispielsweise mittels einer Welle (17), für dessen manuelle Drehung aufweist.

12. Einrichtung zur Einstellung von Drehwinkeln nach einem der Ansprüche 1 bis 11, **dadurch gekennzeichnet, dass** die Handhabe (16) an der dem Gehäuse (12) abgewandten Seite der Halterung (14) befindlich ist, und dass vorzugsweise in der Halterung (14) eine mit der offenen Seite (6) der Aufnahme (8) im Stator (2) korrespondierende Öffnung (19) befindlich ist, durch die die Welle (17) zum Einstecken in die Ausnehmung (18) hindurchreicht.

13. Einrichtung zur Einstellung von Drehwinkeln nach einem der Ansprüche 1 bis 12, **dadurch gekennzeichnet, dass** die Drehwinkelpositionen des Rotors (2) als Raststellungen ausgestaltet sind.

14. Einrichtung zur Einstellung von Drehwinkeln nach einem der Ansprüche 1 bis 13, **dadurch gekennzeichnet, dass** ein elektrischer Schalter im Gehäuse (12) als Netzschalter befindlich ist.

15. Einrichtung zur Einstellung von Drehwinkeln nach einem der Ansprüche.1 bis 14, **dadurch gekennzeichnet, dass** der Magnet (4) an einem Zwischenstück (21) befestigt ist, und dass das Zwischenstück (21) am Rotor (8), insbesondere drehbar, gelagert ist.

16. Einrichtung zur Einstellung von Drehwinkeln nach einem der vorangehenden Ansprüche, **dadurch gekennzeichnet, dass** der Magnet (4) zur Einstellung seiner Lage gegenüber dem Rotor (3) verstellbar angeordnet ist, derart dass eine Justierung der Lage des Magneten (4) in einer Drehwinkelposition des Rotors (3) ermöglicht ist.

17. Einrichtung zur Einstellung von Drehwinkeln nach Anspruch 16, **dadurch gekennzeichnet, dass**, der Magnet (4) drehbar am Rotor (3), insbesondere in einer dem Magnetfeldsensor (5) zugewandten Aufnahme (20) des Rotors (3), gelagert ist.

18. Einrichtung zur Einstellung von Drehwinkeln nach Anspruch 16 oder 17, **dadurch gekennzeichnet, dass** ein Einstellmittel zur Einstellung der Position des Magneten (4) zwischen dem Magneten (4) und dem Rotor (3) angeordnet ist, wobei vorzugsweise das Einstellmittel als ein drehbar, insbesondere in der Aufnahme (20), am Rotor (3) gelagertes Zwischenstück (21) aus'gebildet ist, und wobei weiter vorzugsweise der Magnet (4) am Zwischenstück (21) befestigt ist.

19. Einrichtung zur Einstellung von Drehwinkeln nach Anspruch 16, 17 oder 18, **dadurch gekennzeichnet, dass** der Magnet (4) zur Justierung von der Außenseite des' Stators (2), insbesondere durch eine an einer Seite (6) offene, als Drehlager für den Rotor (3) dienende Aufnahme (8) im Stator (2), zugänglich ist, wobei vorzugsweise im Rotor (3) ein Durchbruch. (22) befindlich ist.

20. Einrichtung zur Einstellung von Drehwinkeln nach einem der Ansprüche, 16 bis 19, **dadurch gekennzeichnet, dass** der Durchbruch (22) von der der offenen Seite (6) der Aufnahme (8) zugewandten Fläche des Rotors (3) bis zum Magneten (4) und/oder bis zum Zwischenstück (21) reicht, und dass vorzugsweise dem Durchbruch (22) zugewandt im Magnet (4) und/oder im Zwischenstück (21) eine Art von Torx, Kreuzschlitz o.dgl. -Aufnahme (23) befindlich ist, derart dass die Justierung über den Durchbruch (22) mittels eines in die Aufnahme (23) eingreifenden Werkzeuges, beispielsweise mittels eines Schraubendrehers, ermöglicht ist.

21. Einrichtung zur Einstellung von Drehwinkeln nach einem der Ansprüche 16 bis 20, **dadurch gekennzeichnet, dass** die justierte Lage des Magneten (4) verdrehsicher mit dem Rotor (3) verbindbar ist, insbesondere indem der Magnet (4) und/oder das Zwischenstück (21) nach dem Justieren mit dem Rotor (3) verklebt, verschweißt, vergossen o. dgl. wird.

22. Einrichtung zur Einstellung von Drehwinkeln nach einem der Ansprüche 16 bis 21, **dadurch gekennzeichnet, dass** der Magnet (4) aus einem Magnetpartikel und Kunststoff aufweisenden Material besteht, wobei vorzugsweise das Material in Gestalt eines derartigen Körpers geformt; insbesondere spritzgegossen ist, dass der Körper gleichzeitig das Zwischenstück (21) sowie den Magneten (4) darstellt.

## Claims

1. A device for adjusting rotation angles, in particular electric rotary switches (1), with a stator (2), which comprises a recess (8), which is open on one side (6) and is approximately in the form of a pot, with a rotor (3), which is mounted rotatably on the stator (2) in the recess (8) as a rotary bearing, so that the rotor (3) can be adjusted between at least two rotation angle positions, with a magnet (4) which can be moved by means of the rotor (3), and with a magnetic field sensor (5) allocated to the magnet (4) for generating a signal corresponding to the rotation angle position, wherein the magnetic field sensor (5) is arranged in the recess (8) on the stator (2) and/or a part which is secured in the stator (2), such that the stator (2) acts as a support for the magnetic field sensor (5), **characterised in that** the magnet (4) is designed as a two-dimensional, diametrically magnetised cylindrical permanent magnet, **in that** the magnetic field sensor (5) is designed as a two-dimensionally sensitive Hall sensor for magnetic fields parallel to its chip surface, and **in that** the magnetic field sensor (5) is secured onto underside of the stator (2), which is located on the side (7) of the recess (8) facing away from the open side (6).

2. The device for adjusting rotation angles according to claim 1, **characterised in that** the stator (2) and/or the rotor (3) are made of plastic, in particular a thermoplastic, for example polyamide, and **in that** preferably the stator (2) and/or the rotor (3) is produced as an injection moulded part.

3. The device for adjusting rotation angles according to claim 1 or 2, **characterised in that** the rotor (3) is located essentially, in particular completely, in the recess (8), so that a surface (25) of the recess (8) located on the inside of the stator (2) functions as a rotary bearing, and **in that** preferably locking elements (26) interact between the stator (2) and the rotor (3) so that the rotor (3) is secured in the recess (8) from falling out.

4. The device for adjusting rotation angles according to claim 1, 2 or 3, **characterised in that** in the stator (2) there are conductor tracks (9) for the electrical connection of the magnetic field sensor (5), and **in that** preferably the conductor tracks (9) extend into the recess (8), wherein particularly in the case of the conductor tracks (9) this is the part secured in the stator (2) for the arrangement of the magnetic field sensor (5).

5. The device for adjusting rotation angles according to one of claims 1 to 4, **characterised in that** the conductor tracks (9) are designed in the form of a metal stamped grid, wherein in particular the stamped grid is injected into the plastic for the injection moulded part for the production of the stator (2).

6. The device for adjusting rotation angles according to one of claims 1 to 4, **characterised in that** the conductor tracks (9) are incorporated into the stator (2) in the form of an MID (Moulded Interconnected Device) component, for example by metallised plastic for the conductor tracks (9).

7. The device for adjusting rotation angles according to one of claims 1 to 6, **characterised in that** the magnetic field sensor (5) is designed as an encapsulated chip with connections (11), in particular in the form of an SMD (Surface Mounted Device) component, wherein the connections (11) are soldered to the conductor tracks (9) for electrical contact.

8. The device for adjusting rotation angles according to one of claims 1 to 6, **characterised in that** the magnetic field sensor (5) is designed as an unencapsulated chip, wherein bonding wires (24), which are welded in particular to the chip, are used for electrically contacting the conductor tracks (9).

9. The device for adjusting rotation angles according to one of claims 1 to 8, **characterised in that** outside of the stator (2) is designed in the form of a housing (12), **in that** preferably locking and/or snap hooks (13) are arranged on the housing (12) for securing the stator (2) to a holder (14), wherein in particular the stator (2) with the open side (6) of the recess (8) faces the holder (14).

10. The device for adjusting rotation angles according to one of claims 1 to 9, **characterised in that** the holder (14) is a circuit board, which if necessary is provided with an aperture for an electrical device or the like, wherein in particular the conductor tracks (9) in the stator (2) contact allocated conductor tracks on the circuit board, and **in that** preferably electronics (15) for evaluating the signals produced by the magnetic field sensor (5) are located on the circuit board.

11. The device for adjusting rotation angles according to one of claims 1 to 10, **characterised in that** the rotor (3) on the open side (6) of the recess (8) comprises a recess (18) for inserting a handle (16), for example by way of a shaft (17), for its manual rotation.

12. The device for adjusting rotation angles according to one of claims 1 to 11, **characterised in that** the handle (16) is located on the side of the holder (14) facing away from the housing (12), and **in that** preferably in the holder (14) there is an opening (19) corresponding with the open side (6) of the recess (8) in the stator (2), through which the shaft (17) extends for insertion into the recess (18).

13. The device for adjusting rotation angles according to one of claims 1 to 12, **characterised in that** the rotation angle positions of the rotor (2) are configured as locking positions.

14. The device for adjusting rotation angles according to one of claims 1 to 13, **characterised in that** an electric switch is situated in the housing (12) as a mains switch.

15. The device for adjusting rotation angles according to one of claims 1 to 14, **characterised in that** the magnet (4) is secured to a connecting piece (21), and **in that** the connecting piece (21) is mounted on the rotor (8), in particular rotatably.

16. The device for adjusting rotation angles according to one of the preceding claims, **characterised in that** the magnet (4) is arranged adjustably for adjusting its position relative to the rotor (3), to enable an adjustment of the position of the magnet (4) in a rotation angle position of the rotor (3).

17. The device for adjusting rotation angles according to claim 16, **characterised in that** the magnet (4) is mounted rotatably on the rotor (3), in particular in a recess (20) of the rotor (3) facing the magnetic field sensor (5).

18. The device for adjusting rotation angles according to claim 16 or 17, **characterised in that** an adjusting means for adjusting the position of the magnet (4) is arranged between the magnet (4) and the rotor (3), wherein preferably the adjusting means is designed as a connecting piece (21) mounted rotatably on the rotor (3), in particular in the recess (20), and whereby also preferably the magnet (4) is secured to the connecting piece (21).

19. The device for adjusting rotation angles according to claim 16, 17 or 18, **characterised in that** the magnet (4) for adjustment from the outside of the stator (2) is accessible in particular through a recess (8) in the stator (2) that is open on one side (6) and functions as a rotary bearing for the rotor (3), wherein preferably an opening (22) is located in the rotor (3).

20. A device for adjusting rotation angles according to one of claims 16 to 19, **characterised in that** the opening (22) extends from the surface of the rotor (3) facing the open side (6) of the recess (8) up to the magnet (4) and/or up to the connecting piece (21), and **in that** preferably facing the opening (22) in the magnet (4) and/or in the connecting piece (21) a kind of torx, recessed head or similar recess (23) is formed, so that the adjustment is made possible through the opening (22) by means of a tool engaging in the recess (23), for example by means of a screwdriver.

21. The device for adjusting rotation angles according to one of claims 16 to 20, **characterised in that** the adjusted position of the magnet (4) can be connected in a rotation-fast manner with the rotor (3), in particular **in that** the magnet (4) and/or the connecting piece (21) is connected to the rotor (3) after adjustment by adhesively bonding, welding or casting or the like.

22. The device for adjusting rotation angles according to one of claims 16 to 21, **characterised in that** the magnet (4) is made from a material which consists of magnet particles and plastic, wherein preferably the material is moulded in the form of such a body, in particular is injection moulded, **in that** the body simultaneously represents the connecting piece (21) and the magnet (4).

## Revendications

1. Installation pour régler des angles de rotation, notamment de commutateurs électriques rotatifs (1), composant un stator (2) avec un logement (8) sensiblement en forme de pot, ouvert d'un côté (6),
un rotor (3) monté mobile en rotation dans le logement (8) du stator (2) sous la forme d'un palier tournant de façon que le rotor (3) puisse être ajusté entre au moins deux positions angulaires de rotation,
un aimant (4) pouvant être déplacé au moyen du rotor (3) et
un capteur de champ magnétique (5) associé à l'aimant (4) pour générer un signal correspondant à la position angulaire de rotation,
le capteur de champ magnétique (5) étant installé dans le logement (8) du stator (2) et/ou dans une pièce fixée au stator (2) pour que le stator (2) serve de support pour le capteur de champ magnétique (5),
**caractérisée en ce que**
l'aimant (4) est réalisé sous la forme d'un aimant permanent de forme cylindrique, à deux dimensions, à aimantation diamétrale,
le capteur de champ magnétique (5) est réalisé sous la forme d'un capteur à effet Hall sensible à deux dimensions, pour les champs magnétiques parallèles à la surface de sa puce et
le capteur de champ magnétique (5) est fixé sur la face inférieure du stator (2), située côté (7) du logement (8) non tourné vers le côté ouvert (6).

2. Installation pour régler des angles de rotation selon la revendication 1,
**caractérisée en ce que**
le stator (2) et/ou le rotor (3) sont en matière plastique, notamment en une matière thermoplastique, par exemple en polyamide et le stator (2) et/ou le rotor (3) sont de préférence des pièces injectées.

3. Installation pour régler des angles de rotation selon la revendication 1 ou 2,
**caractérisée en ce que**
le rotor (3) est logé pour l'essentiel et notamment totalement dans le logement (8) de façon qu'une surface (25) du logement (8) qui se trouve à l'intérieur du stator (2) fonctionne comme palier de rotation et
de préférence des éléments d'enclipsage (26), coopèrent entre le stator (2) et le rotor (3), pour sécuriser le rotor (3) contre les chutes dans le logement (8).

4. Installation pour régler des angles de rotation selon les revendications 1, 2, 3,
**caractérisée en ce que**
le stator (2) comporte des chemins conducteurs (9) pour relier électriquement le capteur de champ magnétique (5) et
de préférence les chemins conducteurs (9) arrivent jusqu'au logement (8),
les chemins conducteurs (9) étant notamment constitués par la pièce fixée au stator (2) pour installer le capteur de champ magnétique (5).

5. Installation pour régler des angles de rotation selon l'une des revendications 1 à 4,
**caractérisée en ce que**
les chemins conducteurs (9) sont réalisés en métal à la manière d'une grille emboutie, la grille emboutie étant notamment intégrée par injection dans la matière plastique de la pièce injectée lors de la fabrication du stator (2).

6. Installation pour régler des angles de rotation selon l'une des revendications 1 à 4,
**caractérisée en ce que**
les chemins conducteurs (9) sont réalisés dans le stator (2) à la manière d'un composant MID (dispositif relié par moulage), par exemple en matière plastique métallisée pour les chemins conducteurs (9).

7. Installation pour régler des angles de rotation selon l'une des revendications 1 à 6,
**caractérisée en ce que**
le capteur de champ magnétique (5) est réalisé sous la forme d'une puce encapsulée munie de branchements (11), notamment à la matière d'un composant SMD (composant monté en surface), les branchements (11) étant soudés aux chemins conducteurs (9) pour réaliser les contacts électriques.

8. Installation pour régler des angles de rotation selon l'une des revendications 1 à 6,
**caractérisée en ce que**
le capteur de champ magnétique (5) est réalisé sous la forme d'une puce non encapsulée, des fils de liaison (24), notamment soudés à la puce, servant à la mise en contact électrique avec les chemins conducteurs (9).

9. Installation pour régler des angles de rotation selon l'une des revendications 1 à 8,
**caractérisée en ce que**
l'extérieur du stator (2) est réalisé à la manière d'un boîtier (12), et des crochets d'enclipsage et/ou d'encliquetage (13) sont de préférence réalisés sur le boîtier (12) pour fixer le stator (2) à un support (14), le stator (2) étant notamment tourné avec le côté ouvert (6) du logement (8) vers le support (14).

10. Installation pour régler des angles de rotation selon l'une des revendications 1 à 9,
**caractérisée en ce que**
le support (14) est constitué par une plaque de circuit munie le cas échéant d'un écran pour un appareil électrique ou similaire, les chemins conducteurs (9) du stator (2) étant notamment en contact avec des chemins conducteurs correspondants de la plaque de circuit, et la plaque de circuit porte de préférence une électronique (15) pour exploiter les signaux générés par le capteur de champ magnétique (5).

11. Installation pour régler des angles de rotation selon l'une des revendications 1 à 10,
**caractérisée en ce que**
sur le côté ouvert (6) du logement (8) le rotor (3) comporte une cavité (18) pour recevoir une poignée (16), par exemple à l'aide d'un arbre (17) pour permettre de la faire tourner manuellement.

12. Installation pour régler des angles de rotation selon l'une des revendications 1 à 11,
**caractérisée en ce que**
la poignée (16) est située sur le côté du support (14) opposé au boîtier (12) et
le support (14) comporte de préférence une ouverture (19) correspondant avec le côté ouvert (6) du logement (8) du stator (2), ouverture traversée par l'arbre (17) pour permettre son engagement dans la cavité (18).

13. Installation pour régler des angles de rotation selon l'une des revendications 1 à 12,
**caractérisée en ce que**
les positions angulaires de rotation du rotor (2) sont réalisées sous la forme de positions d'encliquetage.

14. Installation pour régler des angles de rotation selon l'une des revendications 1 à 13,
**caractérisée en ce que**
un commutateur électrique réalisé sous la forme d'un commutateur de branchement sur le réseau est situé dans le boîtier (12).

15. Installation pour régler des angles de rotation selon l'une des revendications 1 à 14,
**caractérisée en ce que**
l'aimant (4) est fixé à une pièce intermédiaire (21) et **en ce que** cette pièce intermédiaire (21) est montée sur le rotor (8), notamment en rotation.

16. Installation pour régler des angles de rotation selon l'une des revendications précédentes,
**caractérisée en ce que**
l'aimant (4) est monté de manière réglable pour régler sa position par rapport au rotor (3) de façon à permettre un ajustage de la position de l'aimant (4) dans une position angulaire de rotation du rotor (3).

17. Installation pour régler des angles de rotation selon la revendication 16,
**caractérisée en ce que**
l'aimant (4) est monté à rotation sur le rotor (3), notamment dans un logement (20) du rotor (3) tourné vers le capteur de champ magnétique (5).

18. Installation pour régler des angles de rotation selon les revendications 16 ou 17,
**caractérisée par**
un moyen de réglage pour régler la position de l'aimant (4) entre l'aimant (4) et le rotor (3) et le moyen de réglage est de préférence réalisé sous la forme d'une pièce intermédiaire (21) rotative, montée sur le rotor (3) notamment dans le logement (20) et en outre l'aimant (4) étant de préférence fixé à la pièce intermédiaire (21).

19. Installation pour régler des angles de rotation selon les revendications 16, 17, 18,
**caractérisée en ce que**
pour permettre un ajustement du côté extérieur du stator (2), l'aimant (4) est accessible notamment à travers un logement (8) du stator (2), ouvert sur le côté (6) et servant de palier de rotation au rotor (3), de préférence
et le rotor (3) comporte un passage (22).

20. Installation pour régler des angles de rotation selon l'une des revendications 16 à 19,
**caractérisée en ce que**
le passage (22) s'étend de la surface du rotor (3) tournée vers le côté ouvert (6) du logement (8) jusqu'à l'aimant (4) et/ou jusqu'à la pièce intermédiaire (21) et du côté du passage (22) il est de préférence prévu dans l'aimant (4) et/ou dans la pièce intermédiaire (21) une empreinte de type empreinte Torx, croisillon ou autre logement (23) de façon que l'ajustage puisse se faire par le passage (22) à l'aide d'un outil en prise dans le logement (23) par exemple à l'aide d'un tournevis.

21. Installation pour régler des angles de rotation selon l'une des revendications 16 à 20,
**caractérisée en ce que**
la position ajustée de l'aimant (4) est bloquée solidairement en rotation au rotor (3), notamment suite au fait que l'aimant (4) et/ou la pièce intermédiaire (21) est collé, soudé ou scellé avec le rotor (3) après l'ajustage.

22. Installation pour régler des angles de rotation selon l'une des revendications 16 à 21,
**caractérisée en ce que**
l'aimant (4) est en une matière comprenant des particules d'aimant et de la matière plastique, cette matière étant de préférence mise en forme, notamment par injection, de façon à obtenir une pièce constituant en même temps la pièce intermédiaire (21) et l'aimant (4).
